# EUROPEAN PATENT SPECIFICATION

(11) **EP 2 367 234 B1**
(45) Date of publication and mention of the grant of the patent: **16.09.2015**
(21) Application number: 11382066.6
(22) Date of filing: 14.03.2011
(51) Int. Cl.: H01Q 17/00

(54) **Paint with metallic microwires, process for integrating metallic microwires in paint and process for applying said paint on metallic surfaces**
Farbe mit metallischen Mikrodrähten, Verfahren zum Einbringen der metallischen Mikrodrähte in die Farbe und Verfahren zur Anwendung der besagten Farbe auf Metalloberflächen
Peinture dotée de microfils métalliques, procédé pour intégrer les microfils métalliques dans la peinture et procédé pour appliquer ladite peinture sur des surfaces métalliques

(30) Priority: 15.03.2010 ES 201030378
(43) Date of publication of application: 21.09.2011
(73) Proprietor: Micromag 2000, S.L., 28010 Madrid (ES)
(72) Inventor: Cortina Blanco, Daniel, 28010, MADRID (ES); Marin Palacios, Pilar, 28010, MADRID (ES); Hernando Grande, Antonio, 28010, MADRID (ES); Gonzalez Gorriti, Ainhoa, 28010, MADRID (ES)
(74) Representative: Elzaburu Marquez, Alberto

(56) References cited:
- EP-A1- 1 675 217
- WO-A1-93/22774
- GB-A- 2 450 593
- US-A- 5 085 931
- US-A1- 2002 046 849
- US-A1- 2009 075 068

## Description

### Field of the Invention

The invention is comprised in the technical field of metamaterials or composites, also covering aspects of electromagnetism, magnetic absorbers and metallurgy.

### Background of the invention

Multiple applications which require eliminating reflections of electromagnetic radiation are known.

Thus, for example, microwave absorbers are made by tuning electromagnetic properties, in other words, the electric permittivity or the magnetic permeability of certain materials. To that end, it is necessary to disperse small sized metallic elements in a dielectric matrix. Various inventions show these types of solutions, as is the case of United States patent US-5147718, in which a radar absorber based on the dispersion of carbonyl iron powder into a paint is described. The solution is also shown in patent document WO 03/004202 which shows a method for making an electromagnetic radiation absorber based on the dispersion of flakes of an iron-silicon alloy. The solution is also shown in United States patent US-5085931 in which an electromagnetic radiation absorber is formed by dispersing acicular magnetic filaments into a dielectric matrix.

Some absorbers based on amorphous magnetic microwires obtained by the Taylor technique ("The preparation, properties and applications of some glass coated metal filaments prepared by the Taylor-wire process", W. Donald et al., Journal of Material Science, 31, 1996, pp. 1139-1148) can be included among magnetic type absorbers. This type of absorber can be a dielectric matrix in which amorphous magnetic microwires with high magnetic anisotropy having magnetic resonance properties are randomly distributed, as described in European patent EP-1675217.

It is known per document EP 1675217 A1 a structure comprising three layers: Dielectric, Composite, Dielectric, attenuating frequencies between 0.5 and 20 GHz, in single band absorption. However, in this document it is not disclosed the method of integration and application of specific RAMs of paint.

Also known in the art is document US 5085931 A, disclosing a structure having as inclusions: acicular magnetic metallic filaments length < 10 µm, aspect ratios (length/diameter) between 10:1 and 50:1, with volume fraction that may be lower than 35%. The resulting paint is formed by dissolving the absorber (dielectric binder + inclusions) into paint by a complex methodology. The volume fraction of inclusions are rather large in comparison to our proposed technology.

Document WO 93/22774 discloses a mixture of polymeric or liquid matrix material and a combination of conductive powders, fibres and optional flake component, with: 1 to 10 % of one or more conductive fibres, 10 to 60% of one or more conductive metal powder, 0 to 35% of conductive metal flake material, 0 to 25% of organic compound, fibre length from 0.1 to 0.5 inches (2.5 - 13 mm), diameter of about 3 - 15 microns and sheets of composite of 1/8 inches (3.2 mm) with broad band shielding properties. However, this structure cannot be implemented into a thin layer structure, and it acts as a shield, not as an absorber.

Known from document US 2009/0075068 A1 are flake inclusions (metal or ferrite) with a high mass fraction, in a composite onto a shielding of EM waves, applied to communication cables to reduce noise between communication devices. The total layer thickness is between 17 and 70 mm. However, this structure has a high mass fraction, and it cannot be implemented into a thin layer structure.

Document GB 2450593 A of the prior art discloses an optical multiplexer to receive and transmit optical signal via fibre optic cables, with an electrically conductive paint, polymer or adhesive covering at least portions of one of the external surfaces. Conductivity is selected to shield EMI, EMP or ESD. Paint, polymer, elastomer or adhesive loaded with at least one type of the following electrically conductive particles: carbon fibres, flakes and particles, carbon black, graphite, nanoparticles, metal beads, flakes or particles, and metal glass or ceramic beads, flakes or particles coated with metal such as silver, copper, nickel, tin, zinc or aluminium, are disclosed. Again, this structure has a high mass fraction, and it cannot be implemented into a thin layer structure. Furthermore, it is designed to act as a shield, so that it will not allow the electromagnetic radiation to go through it, but will reflect it, not absorb it.

Document US 2002/2046846 A1 in the prior art discloses shields for EMI for access panels and doors in electronic equipment enclosures, with electrically non conductive substrate in combination with an electrically conductive element. This structure has four aspects: substrate + conductive layer, metal wool + foamable mixture, polyol + isocyanate + conductive particles (metal particles, conductive polymers...), polymeric fibre fabric + electrolessly plated. However, this document relates to the manufacturing of a layer of material that is highly conductive but can also be shaped for door or panels in electronic equipment enclosures, therefore, any GHz wave will be highly reflected by the surface, not attenuated.

### Description of the Invention

The invention relates to a process for integrating amorphous metallic microwires in paint according to claim 1. The preferred embodiments are described in the dependent claims.

A first aspect of the invention relates to a paint with amorphous metallic microwires for attenuating the reflectivity of electromagnetic radiation, the paint having a determined dielectric constant εᵣ; the paint comprises:
- a proportion X of amorphous metallic microwires having a length ℓ and a metallic core of diameter d_{c};
- a solvent corresponding to said paint in an amount less than 20%;
the maximum attenuation frequency of the reflectivity of said electromagnetic radiation having a range which is determined by the length ℓ and the diameter d_{c} of the metallic core of the amorphous metallic microwires, by the proportion of amorphous metallic microwires in the paint, and by the dielectric constant of the paint without amorphous metallic microwires.

A second aspect of the present invention relates to a process for integrating amorphous metallic microwires in a paint for attenuating the reflectivity of electromagnetic radiation, the paint having a certain dielectric constant εᵣ; the process comprises:
- liquefying the paint with a solvent corresponding to the type of said paint;
- adding amorphous metallic microwires in a proportion X to said liquefied paint, the amorphous metallic microwires having a length ℓ and a metallic core of diameter d_{c};
- beating the mixture of paint with amorphous metallic microwires at a maximum speed depending on the length of the amorphous metallic microwires;
the range of maximum attenuation frequencies of the reflectivity of said electromagnetic radiation being determined by the length ℓ and the diameter d_{c} of the metallic core of the amorphous metallic microwires, by the proportion X of amorphous metallic microwires in the paint, and by the dielectric constant of the paint without amorphous metallic microwires.

The amount of solvent used for liquefying the paint must not be greater than 20%.

The metallic microwire used in the present invention is preferably a metallic filament of high electrical conductivity or of an amorphous magnetic alloy with Pyrex coating, in which the diameter of the core and the total diameter are not greater than 100 and 200 µm, and with a length comprised between 0.1 and 20 mm,

The beating for integrating the microwire in the paint is preferably performed with a mixing rod at a maximum speed of 2500 r.p.m.

Another aspect of the invention relates to the application of said paint with microwires on a metallic surface for the attenuation of the reflectivity of electromagnetic radiation which comprises:
- applying a first coat of primer on the metallic surface, said first coat having a first dielectric constant εᵣ₁ and a first thickness d1;
- applying on the first coat a second coat of paint, said second coat having a second dielectric constant εᵣ₂ and a second thickness d2;
- applying on said second coat an active third coat of a paint containing microwires as defined above, i.e., a paint with amorphous metallic microwires with a known composition and which provides a range of maximum attenuation frequencies of reflectivity of electromagnetic radiation, said third coat having a third dielectric constant εᵣ₃ and a third thickness d3; and
- sanding said active third coat with fine grain sandpaper to remove the amorphous metallic microwires orientated perpendicular to the plane of the metallic surface,
the maximum attenuation frequency of the reflectivity of said electromagnetic radiation being determined within the range of maximum attenuation frequencies given by the paint with amorphous metallic microwires, by the first, second and third thicknesses d1, d2, d3 and by the first, second and third dielectric constants εᵣ₁, εᵣ₂, εᵣ₃ of the different coats.

The process preferably includes an additional step of:
- applying a fourth coat of finish paint, said fourth coat having a fourth dielectric constant εᵣ₄ and a fourth thickness d4.

The metallic surface can be a composite with high conductivity, or it can also be a metallised plastic, for example, by means of metallic adhesive tapes or with metallic paint.

The paint can be applied by means of a spray gun, roller or airless system.

Preferably, the amorphous metallic microwires used in the spray or airless gun application method do not have lengths greater than 5 mm.

Preferably, the amorphous metallic microwires used in the roller application method do not have lengths greater than 20 mm.

The following must be considered with regard to the application steps:
The first coat of primer has a dielectric constant, εᵣ₁ with a real part preferably comprised between 2 and 4, it is applied on the metallic surface and its thickness can be comprised between 20 and 100 µm.
The second coat of paint can have a thickness between 25 µm and 5000 µm with a real part of the dielectric constant εᵣ₂ between 2 and 9 and it is applied on the first coat of primer.
This second coat of paint can contain amorphous metallic microwires; in this case, its dielectric constant εᵣ₂ can range between 2 and 500.

The values of the real part of the dielectric constant of the second coat εᵣ₂ can be modified by varying the percentage by weight of the amorphous metallic microwires between 0.5 and 5%.

The active third coat can have a thickness between 75 and 500 µm, and the real part of its dielectric constant εᵣ₃ can be between 9 and 1000, and it is modified based on a percentage by weight of the amorphous metallic microwires comprised between 0.5 and 10% by weight.

The fourth coat of finish paint can have a thickness between 25 and 100 µm, and the real part of its dielectric constant εᵣ₄ can be comprised between 2 and 9.

Preferably, the fourth coat of finish paint does not contain a high density of metallic or carbon particles; otherwise it can reflect electromagnetic radiation.

The thickness of the second coat, which is the coat that mainly determines at what distance the active third coat with the amorphous metallic microwires of the metallic surface is located, greatly influences the tuning frequency for the attenuation of electromagnetic radiations.

The tuning frequency can range between 0.1 and 70 GHz for a sum of thicknesses of the second and third coats between 25 and 5000 µm.

### Brief Description of the Drawings

To complement the description which is being made and for the object of aiding to better understand the features of the invention according to a preferred practical embodiment thereof, a set of drawings is attached as an integral part of said description in which the following has been depicted with an illustrative and non-limiting character:
Figures 1 and 2 show a sectional view of respective metallic surfaces painted according to the process of the invention, with a variation in the second coat.
Figure 3 shows the resulting attenuation spectrum after applying the painting process of the invention shown in Figure 1.
Figure 4 shows the resulting attenuation spectrum after applying the painting process of the invention shown in Figure 2.

### Preferred Embodiment of the Invention

A preferred embodiment of the process for integrating amorphous metallic microwires in paint is described below. This process includes:
- liquefying the paint with a solvent which is suitable for said paint in an amount no greater than 20%;
- adding to the previously dissolved paint a determined amount of amorphous metallic microwires with determined length ℓ and diameter of the metallic core d_{c};
- beating the mixture using a mixing rod at low speed (preferably at a speed no greater than 2500 rpm) so as not to break the amorphous metallic microwires.

The process object of the invention has been confirmed as effective for painting on a metallic surface in two cases: both with amorphous metallic microwires with the same composition, Fe₈₉Si₃B₁C₃Mn₄ and varying the geometry thereof.

In the first case amorphous metallic microwires with a diameter of the metallic core of 20 µm and a length of 3 mm were used. The amorphous metallic microwires were integrated in the paint by beating with a mixing rod at 1700 rpm, the paint having a real part of the dielectric constant, εᵣ of value 4 lowered with 5% solvent.

A first coat 2 of primer of 30 µm and with a real part of the dielectric constant εᵣ of value 4 was applied on the metallic surface 1.

A second coat 3 of paint without amorphous metallic microwires with a thickness of 700 µm was then applied, resulting in a real part of the dielectric constant εᵣ of 6.5.

A third active coat 4 was then applied on the second coat 3, the third active coat containing amorphous metallic microwires in a density of 2% by weight, with a thickness of 300 µm, and resulting in a real part of the dielectric constant εᵣ of 75.

A fourth coat 5 of finish was then applied on the third active coat, this coat having a thickness of 100 µm, and a dielectric constant εᵣ of 6.5.

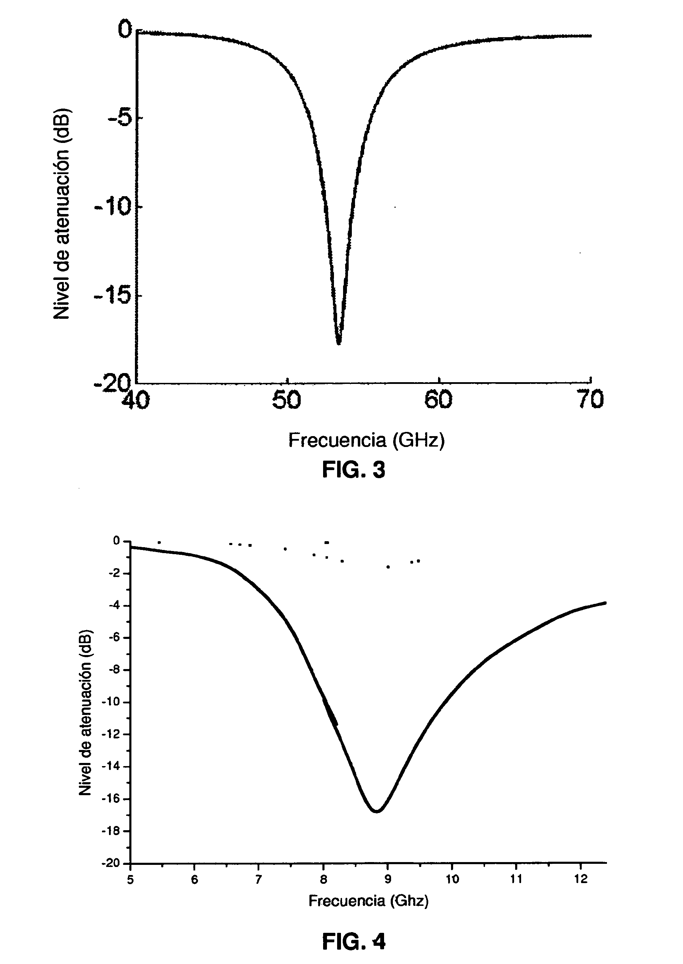

The paint thus obtained has a reflectivity with an attenuation centred on 5.3 GHz with a level of 18 dB and with a level of attenuation greater than 10 dB for a bandwidth of 1.6 GHz centred on 5.3 GHz, as shown in the graph of Figure 3.

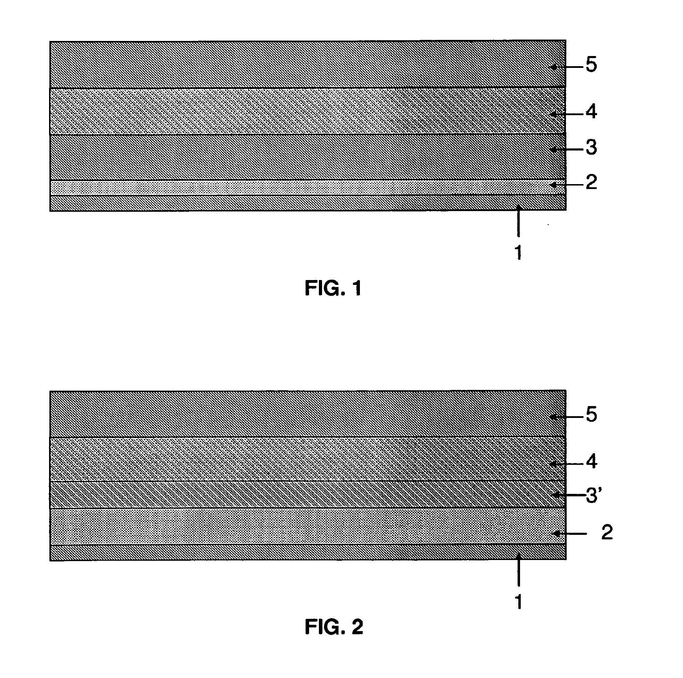

Figure 1 shows a sectioned view of the result of painting a metallic surface according to the process of the invention. The following can be seen in this figure:
- the metallic surface 1,
- the first coat 2 of primer,
- the second coat 3 of paint (without amorphous metallic microwires),
- the third "active" coat 4 containing amorphous metallic microwires, and
- the fourth coat 5 of finish.

In the second case, amorphous metallic microwires with a diameter of the metallic core of 8 µm and a length of 2 mm were used. The amorphous metallic microwires were integrated in the paint by beating paint with a real part of the dielectric constant, εᵣ₁ of value 4 lowered with 10% solvent with a mixing rod at 1000 rpm.

A 900 µm first coat 2 of primer with a real part of the dielectric constant εᵣ of value 4 was applied on the metallic 1 surface.

A second coat 3' of paint containing amorphous metallic microwires at a density of 4% by weight, with a thickness of 200 µm was then applied, resulting in a real part of the dielectric constant εᵣ of 60.

The active coat 4 is applied on the second coat 3'; this active coat contained amorphous metallic microwires at a density of 2% by weight.

The coat 5 of finish applied on the active coat 4 had a thickness of 75 µm and a dielectric constant εᵣ of 4.

In this case, the paint obtained has an attenuation curve of electromagnetic waves centred on 9 GHz with a level of -18 dB and with a level of attenuation greater than 10 dB for a bandwidth of 1 GHz centred on 9 GHz, as shown in the graph of Figure 4.

Figure 2 shows a sectioned view of the results of painting a metallic surface according to the process of the invention. The following can be seen in this figure:
- the metallic surface 1,
- the first coat 2 of primer having greater thickness than in the case shown in Figure 1,
- the second coat 3' of paint containing amorphous metallic microwires and having a thickness less than in the case shown in Figure 1,
- the third "active" coat 4 containing amorphous metallic microwires, and
- the fourth coat 5 of finish.

In view of this description and set of drawings, the person skilled in the art will be able to understand that the embodiments of the invention which have been described can be combined in multiple manners within the object of the invention.

## Claims

1. Process for integrating amorphous metallic microwires in a paint for attenuating the reflectivity of electromagnetic radiation, the paint having a certain dielectric constant εᵣ, the process comprising the steps of:
- liquefying the paint with a solvent corresponding to the type of said paint in an amount less than 20%;
- adding amorphous metallic microwires in a proportion X to said liquefied paint, the amorphous metallic microwires having a length ℓ and a metallic core of diameter d_{c}; and
- beating the mixture of paint with amorphous metallic microwires at a maximum speed less than 2500 rpm depending on the length ℓ of the amorphous metallic microwires;
the range of maximum attenuation frequencies of the reflectivity of said electromagnetic radiation being determined by the length ℓ and the diameter d_{c} of the metallic core of the amorphous metallic microwires, by the proportion X of amorphous metallic microwires in the paint, and by the dielectric constant εᵣ of the paint without amorphous metallic microwires.

2. Process according to claim 1, wherein amorphous metallic microwires with diameter of the core d_{c} and total diameter less than 100 and 200 µm, respectively, are used.

3. Process according to any of claims 1-2, wherein amorphous metallic microwires with a length ℓ comprised between 0.1 and 20 mm are used.

## Patentansprüche

1. Verfahren zum Integrieren von amorphen metallischen Mikrodrähten in ein Anstrichmittel zum Verringern des Reflexionsvermögens für elektromagnetische Strahlung, wobei das Anstrichmittel eine bestimmte Dielektrizitätskonstante εᵣ besitzt,
wobei das Verfahren folgende Schritte aufweist:
- Verflüssigen des Anstrichmittels mit einem Lösungsmittel, der dem Typ des Anstrichmittels entspricht, in einer Menge von weniger als 20 %;
- Hinzugeben von amorphen metallischen Mikrodrähten in einem Anteil X zu dem verflüssigten Anstrichmittel, wobei die amorphen metallischen Mikrodrähte eine Länge 1 sowie einen Metallkern mit einem Durchmesser von dc besitzen; und
- Schlagen der Mischung aus dem Anstrichmittel und den amorphen metallischen Mikrodrähten bei einer maximalen Geschwindigkeit von weniger als 2500 min⁻¹, in Abhängigkeit von der Länge 1 der amorphen metallischen Mikrodrähte;
wobei der Bereich von maximalen Dämpfungsfrequenzen des Reflexionsvermögens für elektromagnetische Strahlung bestimmt wird durch die Länge 1 und den Durchmesser dc der Metallkerne der amorphen metallischen Mikrodrähte, durch den Anteil X von amorphen metallischen Mikrodrähten in dem Anstrichmittel, und durch die Dielektrizitätskonstante εᵣ des Anstrichmittels ohne die amorphen metallischen Mikrodrähte.

2. Verfahren nach Anspruch 1,
wobei amorphe metallische Mikrodrähte mit einem Kerndurchmesser von dc und einem Gesamtdurchmesser von weniger als 100 µm bzw. 200 µm verwendet werden.

3. Verfahren nach einem der Ansprüche 1 und 2,
wobei amorphe metallische Mikrodrähte mit einer Länge 1 verwendet werden, die zwischen 0,1 mm und 20 mm liegt.

## Revendications

1. Processus d'intégration de microfils métalliques amorphes dans une peinture pour atténuer la réflectivité d'un rayonnement électromagnétique, la peinture ayant une certaine constante diélectrique εᵣ, le processus comprenant les étapes consistant :
- à liquéfier la peinture avec un solvant correspondant au type de ladite peinture en une quantité inférieure à 20 % ;
- à ajouter des microfils métalliques amorphes en une proportion X à ladite peinture liquéfiée, les microfils métalliques amorphes ayant une longueur ℓ et un noyau métallique de diamètre d_{c} ; et
- à battre le mélange de peinture avec les microfils métalliques amorphes à une vitesse maximale inférieure à 2500 tr/min en fonction de la longueur ℓ des microfils métalliques amorphes ;
la plage de fréquences d'atténuation maximales de la réflectivité dudit rayonnement électromagnétique étant déterminée par la longueur ℓ et le diamètre d_{c} du noyau métallique des microfils métalliques amorphes, par la proportion X de microfils métalliques amorphes dans la peinture, et par la constante diélectrique εᵣ de la peinture sans microfils métalliques amorphes.

2. Processus selon la revendication 1, dans lequel des microfils métalliques amorphes avec un diamètre du noyau d_{c} et un diamètre total inférieurs à 100 et 200 µm, respectivement, sont utilisés.

3. Procédé selon l'une des revendications 1 et 2, dans lequel des microfils métalliques amorphes avec une longueur ℓ comprise entre 0,1 et 20 mm sont utilisés.
